# EUROPEAN PATENT SPECIFICATION

(11) **EP 3 128 629 B1**
(45) Date of publication and mention of the grant of the patent: **29.07.2020**
(21) Application number: 16182400.8
(22) Date of filing: 02.08.2016
(51) Int. Cl.: H02G 3/18, H01L 31/02, H02S 40/34

(54) **PHOTOVOLTAIC JUNCTION BOX AND PHOTOVOLTAIC JUNCTION MODULE**
PHOTOVOLTAIKANSCHLUSSKASTEN UND PHOTOVOLTAISCHES ANSCHLUSSMODUL
BOÎTE DE JONCTION PHOTOVOLTAÏQUE ET MODULE DE JONCTION PHOTOVOLTAÏQUE

(30) Priority: 04.08.2015 CN 201510471648
(43) Date of publication of application: 08.02.2017
(73) Proprietor: Tyco Electronics (Shanghai) Co. Ltd., Shanghai (CN); Tyco Electronics Holdings (Bermuda) No. 7 Limited, HM 11 Hamilton (BM)
(72) Inventor: ZHONG, Yuan, Shanghai (CN); TAO, Ting, Shanghai (CN); KO, Shih Ying, 11457 Taipei (TW)
(74) Representative: Grünecker Patent- und Rechtsanwälte PartG mbB

(56) References cited:
- EP-A1- 2 434 549
- EP-A2- 2 330 634
- CN-U- 201 910 434
- CN-U- 202 190 230
- JP-A- 2011 151 025
- KR-B1- 101 483 594
- US-A1- 2010 105 245
- US-B2- 7 972 177

## Description

### CROSS-REFERENCE TO RELATED APPLICATION

This application claims the benefit of Chinese Patent Application No. 201510471648.1 filed on August 4, 2015 in the State Intellectual Property Office of China.

### BACKGROUND OF THE INVENTION

### Field of the Invention

The present disclosure relates to a photovoltaic junction box for electrically connecting with a bus bar of a solar panel, and a photovoltaic junction module comprising the photovoltaic junction box.

### Description of the Related Art

In the prior art, a photovoltaic junction box generally comprises a box body; and a positive conduction terminal, a negative conduction terminal, a diode and an elastic clip, which are all housed in the box body. The diode is connected between the positive conduction terminal and the negative conduction terminal. The elastic clip is adapted to clamp a positive bus bar of the solar panel on the positive conduction terminal and at the same time clamp a negative bus bar of the solar panel on the negative conduction terminal, such that the positive and negative bus bars of the solar panel are electrically connected to the positive and negative conduction terminals, respectively.

The current photovoltaic junction box has the drawbacks, such as complicated structure, relatively high cost and sophisticated operation.

Further, in the current photovoltaic junction box, electrical contact between the bus bar and the conduction terminal is not reliable and quite easy to become loose.

Document EP 2 330 634 A2 discloses a terminal box for a solar cell module having terminal plates which are electrically connected to output terminals of the solar cell module by means of plastically displaceable pressing pieces.

Document KR 101 483 594 B1 discloses a one-touch junction box for photovoltaic modules having a plurality of busbars with a first and second terminal, wherein the second terminal is adapted to receive cables fixed by means of a retention arm of the junction box.

In document US 7,972,177 B2 a slide clip for connecting an output conductor to a solar panel is disclosed, wherein the electric connection between a feed cable and the solar panel is established by means of a snap-on contact clip or a slidable contact clip.

Also in documents CN 202 190 230 U and EP 2 434 549 A1 technological background to the present invention is disclosed. Document JP 2011 151025 A discloses a ribbon-wire fastener provided inside a junction box for solar cell panels comprising an elastic member which is rotatably connected to a side wall by a rotational axis, wherein the elastic member is a bent elastic member having several sections. Also document CN 2019 10434 U discloses a terminal box for photovoltaic applications comprising receving means connectible to a bus-bar and a line terminal by connecting a bottom sheet copper with another sheet copper which are attached to each other or brought into engagement with each other by means of a screw.

### SUMMARY OF THE INVENTION

The object of the present disclosure is to solve the above mentioned technical problems or other technical problems of the prior art

One object of the present disclosure is to provide a photovoltaic conduction box of simple structure, which may realize the reliable electrical connection between a bus bar of a solar panel and a conduction terminal of the photovoltaic conduction box.

According to the present invention, there is provided a photovoltaic connection box according to claim 1.

According to a still exemplary embodiment of the present disclosure, the pressing elastic sheet has the pressing portion projecting downwards and adapted to press the bus bar received in the recession against an internal bottom surface of the recession.

According to a still exemplary embodiment of the present disclosure, a tip portion of the pressing elastic sheet bends upwards and is formed with a slot so as to form a holding portion, which is adapted to be held by an operator, on the pressing elastic sheet.

According to a still exemplary embodiment of the present disclosure, each of the conduction terminals is formed with a stub-shaped protrusion, in which a thread hole is formed, and the base of the pressing elastic sheet is formed with a through-hole; and the pressing elastic sheet is rotatably connected to the conduction terminal by a screw passing through the through-hole and screwed in the thread hole of the stub-shaped protrusion.

According to a still exemplary embodiment of the present disclosure, the recession has a flat internal bottom surface lower than an upper surface of the conduction terminal; the projection has a flat lower surface higher than the upper surface of the conduction terminal; and the bus bar inserted in the positioning slot is defined between the internal bottom surface of the recession and the lower surface of the projection.

According to a still exemplary embodiment of the present disclosure, the internal bottom surface of the recession is provided with soldering material for soldering the bus bar on the internal bottom surface of the recession.

According to a still exemplary embodiment of the present disclosure, the projection is formed at one end of the recession and is aligned with the recession.

According to a still exemplary embodiment of the present disclosure, the conduction terminals comprise a positive conduction terminal and a negative conduction terminal separated from the positive conduction terminal; and the photovoltaic connection box further comprises a diode electrically connected between the positive conduction terminal and the negative conduction terminal.

According to a still exemplary embodiment of the present disclosure, the photovoltaic box further comprises a positive wire electrically connected to positive conduction terminal and a negative wire electrically connected to the negative conduction terminal.

According to another aspect of the present disclosure, there is provided a photovoltaic connection module, wherein, the module comprises an above-mentioned photovoltaic connection box and a solar panel. The bus bar of the solar panel is inserted in the positioning slot so as to be held in place; and the pressing elastic sheet presses the bus bar on the conduction terminal, so that the bus bar reliably comes into electrical contact with the conduction terminal.

According to one exemplary embodiment of the present disclosure, an internal bottom surface of the positioning slot is provided with soldering material for soldering the bus bar on the conduction terminal.

According to a still exemplary embodiment of the present disclosure, after pressing the pressing elastic sheet on the bus bar, the bus bar is soldered on the conduction terminal.

In the various exemplary embodiments of the present disclosure, the bus bar of the solar panel is inserted in the positioning slot of the conduction terminal so as to be held in place. The pressing elastic sheet provided on the conduction terminal presses the bus bar in the positioning slot so as to prevent the bus bar from moving with respect to the conduction terminal and keep the reliable electrical contact between the bus bar and the conduction terminal.

Further, in some exemplary embodiments of the present disclosure, the bus bar is further soldered on the internal bottom surface of the positioning slot so as to further prevent the bus bar from moving with respect to the conduction terminal, such that the electrical connection between the bus bar and the conduction terminal will be more reliable.

### BRIEF DESCRIPTION OF THE DRAWINGS

The above and other features of the present disclosure will become more apparent by describing in detail exemplary embodiments thereof with reference to the accompanying drawings, in which:
Fig.1 shows a schematic perspective view of conduction terminals in a photovoltaic junction box according to an exemplary embodiment of the present disclosure;
Fig. 2 shows a schematic perspective view of a pressing elastic sheet in the photovoltaic junction box according to an exemplary embodiment of the present disclosure;
Fig.3 shows a schematic perspective view of the photovoltaic junction box according to an exemplary embodiment of the present disclosure, wherein, a bus bar has already been inserted in a positioning slot; however, the pressing elastic sheet hasn't pressed against the bus bar; and
Fig. 4 shows a schematic perspective view of the photovoltaic junction box according to an exemplary embodiment of the present disclosure, wherein, the bus bar has already been inserted in the positioning slot, and the pressing elastic sheet has already pressed against the bus bar.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

Furthermore, in the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general technical concept of the invention, there is provided a photovoltaic connection box, comprising: a box body; and a plurality of conduction terminals received in the box body. Each conduction terminal is provided with a bus bar holding mechanism configured to hold a bus bar of a solar panel on the conduction terminal so as to electrically connect the bus bar to the conduction terminal. Each of the bus bar holding mechanisms comprises a positioning slot formed on the conduction terminal and adapted to position the bus bar inserted therein in place; and a pressing elastic sheet mounted on the conduction terminal and adapted to press the bus bar on the conduction terminal, so that the bus bar reliably comes into electrical contact with the conduction terminal.

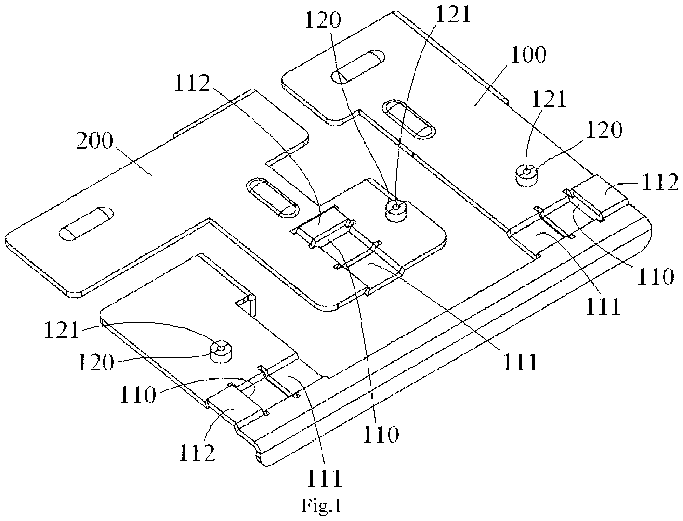

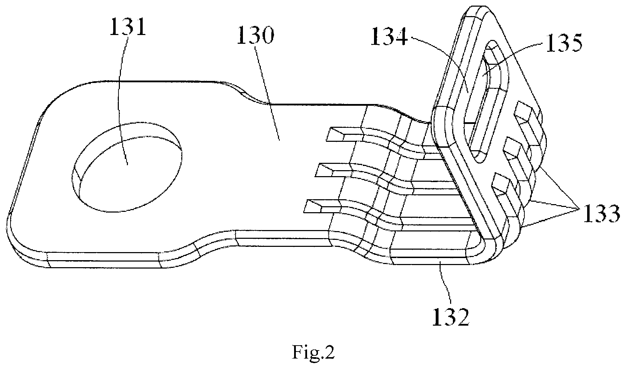

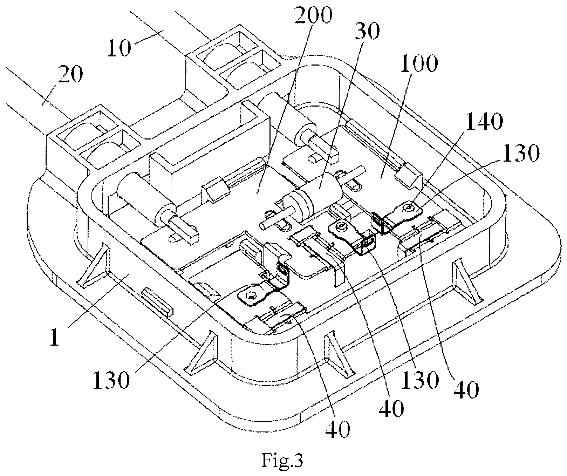

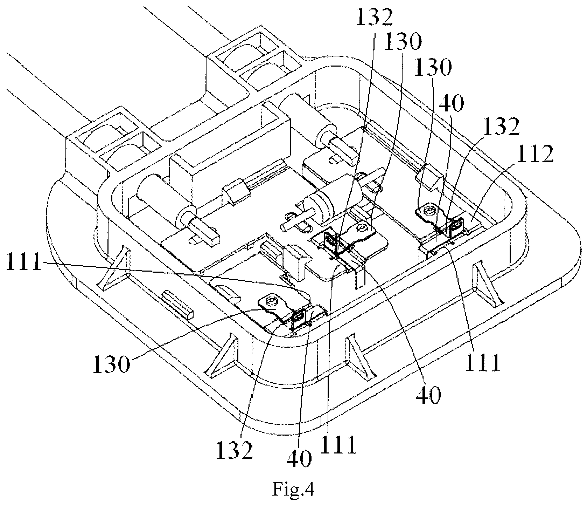

Fig.1 shows a schematic perspective view of the conduction terminals 100 and 200 in a photovoltaic junction box according to an exemplary embodiment of the present disclosure; Fig. 2 shows a schematic perspective view of a pressing elastic sheet 130 in the photovoltaic junction box according to an exemplary embodiment of the present disclosure; Fig.3 shows a schematic perspective view of the photovoltaic junction box according to an exemplary embodiment of the present disclosure, wherein, a bus bar 40 has already been inserted in a positioning slot 110; however, the pressing elastic sheet 130 hasn't yet pressed against the bus bar 40; and Fig. 4 shows a schematic perspective view of the photovoltaic junction box according to an exemplary embodiment of the present disclosure, wherein, the bus bar 40 has already been inserted in the positioning slot 110, and the pressing elastic sheet 130 has already pressed against the bus bar 40.

In an exemplary embodiment of the present disclosure, there is disclosed a photovoltaic junction box. As illustrated in Figs. 3 and 4, the photovoltaic junction box 1 mainly comprises a box body 1, two conduction terminals 100 and 200, and a diode 30.

As clearly illustrated in Fig.3, the conduction terminals 100 and 200 together with the diode 30 are housed in the box body 1. One of the conduction terminals 100 and 200 is acted as a positive conduction terminal 100, and the other of the conduction terminals 100 and 200 is acted as a negative conduction terminal 200. The positive conduction terminal 100 is arranged to be separated from the negative conduction terminal 200, and the diode 30 is electrically connected between the positive conduction terminal 100 and the negative conduction terminal 200. The positive conduction terminal 100 is electrically connected with a positive wire 10, and the negative conduction terminal 200 is electrically connected with a negative wire.

As illustrated in Figs. 1 to 4, in an exemplary embodiment of the present disclosure, each of the conduction terminals 100 and 200 is provided with a bus bar holding mechanism configured to holding a bus bar 40 of a solar panel (not shown) on the conduction terminal 100 or 200 so as to electrically connect the bus bar 40 to the conduction terminal 100 or 200.

Referring to Fig.1 to Fig.4, in an illustrated embodiment, each bus bar holding mechanisms mainly comprises the positioning slot 110 and the pressing elastic sheet 130.

As clearly illustrated in Figs.1, 3 and 4, the positioning slot 110 is formed on each of the conduction terminals 100 and 200, and is adapted to position the bus bar 40 inserted therein in place; and the pressing elastic sheet 130 is mounted on each of the conduction terminals 100 and 200, and is adapted to press the bus bar 40 located in the positioning slot 110 of the conduction terminal 100 or 200, so that the bus bar 40 reliably comes into electrical contact with the conduction terminal 100 or 200.

As clearly illustrated in Figs.1, 3 and 4, the positioning slot 110 is defined by an internal wall surface of a recession 111 and an internal wall surface of a projection 112 both formed on a surface of the conduction terminal 100 or 200 by a punching processing.

As clearly illustrated in Figs.2, 3 and 4, the pressing elastic sheet 130 has a pressing portion 132 projecting downwards and adapted to press the bus bar 40 received in the recession 111 against an internal bottom surface of the recession 111.

As illustrated in Fig.1 to Fig.4, in the illustrated embodiment, a base of the pressing elastic sheet 130 is rotatably connected to the surface of the conduction terminal 100 or 200, so as to allow the pressing elastic sheet 130 to rotate between a first position and a second position.

When the pressing elastic sheet 130 is in the first position (the position as illustrated in Fig.4), the pressing portion 132 of the pressing elastic sheet 130 is located in the recession 111 so as to press the bus bar 40 inserted in the positioning slot 110.

When the pressing elastic sheet 130 is in the second position (the position as illustrated in Fig.3), the pressing portion 132 of the pressing elastic sheet 130 is located outside the recession 111, so as to allow to insert the bus bar 40 in the positioning slot 110 or pull the bus bar 40 out of the positioning slot 110.

As illustrated in Figs.2 and 4, in the illustrated embodiment, a plurality of projecting ribs 133 separated from each other are formed on a bottom surface of the pressing portion 132 of the pressing elastic sheet 130. These projecting ribs 133 is adapted to press against the bus bar 40.

In this way, it is possible to more reliably press the bus bars 40 on the conduction terminals 100 and 200. Further, since only the projecting ribs 133 come into contact with the bus bar 40, the contact resistance between the pressing elastic sheet 130 and the bus bar 40 is reduced.

As clearly illustrated in Fig.2, in the illustrated embodiment, a tip portion of the pressing elastic sheet 130 is bent upwards, and is formed with a slot 135 so as to form a holding portion 134, which is adapted to be held by an operator, on the pressing elastic sheet 130. In this way, the operator may operate the pressing elastic sheet 130 through the holding portion 134, for example, rotating the pressing elastic sheet 130 from the second position as shown in Fig. 3 to the first position as shown in Fig. 4.

As illustrated from Fig.1 to Fig.4, in an exemplary embodiment of the present disclosure, each of the conduction terminals 100 and 200 is provided with a stub-shaped protrusion 120, in which a thread hole 121 is formed; accordingly, a through-hole 131 is formed in the base of the pressing elastic sheet 130. The pressing elastic sheet 130 is rotatably connected to the conduction terminal 100 or 200 by a screw 140. The screw 140 passes through the through-hole 131 and is screwed in the thread hole 121 of the stub-shaped protrusion 120. In this way, the conduction terminal 100 or 200 may rotate about a smooth cylindrical base of the screw 140.

As illustrated in Figs.1 and 3, in an exemplary embodiment of the present disclosure, the recession 111 has a flat internal bottom surface (an upper surface of the recession) lower than an upper surface of the conduction terminal 100 or 200. The projection 112 has a flat internal top surface (the lower surface as shown in Fig. 1) higher than the upper surface of the conduction terminal 100 or 200. The bus bar 40 inserted in the positioning slot 110 is defined between the lower surface of the recession 111 and the internal top surface of the projection 112.

In an exemplary embodiment of the present disclosure, the internal bottom surface of the recession 111 is provided with soldering material, such as tin solder, for soldering the bus bar 40 on the internal bottom surface of the recession 111. In this way, it is possible to further prevent the bus bar 40 from moving with respect to the conduction terminal 100 or 200 by soldering the bus bar on the internal bottom surface of the recession, such that the electrical connection between the bus bar 40 and the conduction terminal 100 or 200 will be more reliable.

In an exemplary embodiment of the present disclosure, after pressing the pressing elastic sheet 130 on the bus bar 40, the bus bar 40 is soldered on the conduction terminal 100 or 200. In this way, when soldering, since the bus bar 40 has already been tightly pressed on the flat internal bottom surface of the recession 111 by the pressing elastic sheet 130, cold solder joint thus may be effectively avoided so as to improve the soldering quality.

As illustrated in Figs.1 and 3, in the illustrated embodiment, the projection 112 on the conduction terminal 100 or 200 is formed at one end of the recession 111 and aligned with the recession 111. In this way, the straight bus bar 40 may smoothly be inserted in the positioning slot 110 defined by the projection 112 together with the recession 111.

It should be appreciated for those skilled in this art that the above embodiments are all exemplary embodiments, and many modifications may be made to the above embodiments by those skilled in this art, and various features described in different embodiments may be freely combined with each other without conflicting in configuration or principle.

Although the present disclosure has been described with reference to the attached drawings, the embodiments disclosed in the attached drawings are intended to describe the preferred embodiments of the present disclosure exemplarily, but should not be construed as a limitation to the present disclosure.

Although several embodiments of the general concept of the present disclosure have been shown and described, it would be appreciated by those skilled in the art that various changes or modifications may be made in these embodiments without departing from the principles of the disclosure, the scope of which is defined in the claims.

As used herein, term "comprising" or "having" should be understood as not excluding other elements or steps, and term "a" or "an" should be understood as not excluding plural elements or steps. In addition, any reference numeral in claims should not be understood as the limitation of the scope of the present disclosure.

## Claims

1. A photovoltaic connection box (1), comprising:
a box body (1);
a plurality of conduction terminals (100, 200) received in the box body (1); and
a plurality of bus bar holding mechanisms provided on the conduction terminals (100, 200), and configured to hold bus bars (40) of a solar panel on the conduction terminals (100, 200), respectively, so as to electrically connect the bus bars (40) to the conduction terminals (100, 200), each bus bar holding mechanisms comprising:
a positioning slot (110) formed on the conduction terminal (100, 200) and adapted to position the bus bar (40) inserted therein in place, wherein the positioning slot (110) is defined by a recession (111) and a projection (112) both formed on the surface of the conduction terminal (100, 200); and
a pressing elastic sheet (130) mounted on the conduction terminal (100, 200) and adapted to press the bus bar (40) on the conduction terminal (100, 200), so that the bus bar (40) reliably comes into electrical contact with the conduction terminal (100, 200), wherein a base of the pressing elastic sheet (130) is rotatably connected to a surface of the conduction terminal (100, 200), so as to allow the pressing elastic sheet (130) to rotate between a first position and a second position;
when the pressing elastic sheet (130) is in the first position, a pressing portion (132) of the pressing elastic sheet (130) is located in the recession (111) so as to press the bus bar (40) inserted in the positioning slot (110); and
when the pressing elastic sheet (130) is in the second position, the pressing portion (132) of the pressing elastic sheet (130) is located outside the recession (111), so as to allow to insert the bus bar (40) in the positioning slot (110) or pull the bus bar (40) out of the positioning slot (110), **characterized in that** a bottom surface of the pressing portion (132) of the pressing elastic sheet (130) is provided with a plurality of projecting ribs (133) separated from each other and adapted to press against the bus bar (40).

2. The photovoltaic connection box (1) according to claim 1, wherein the pressing portion (132) of the pressing elastic sheet (130) is projecting downwards and adapted to press the bus bar (40) received in the recession (111) against an internal bottom surface of the recession (111).

3. The photovoltaic connection box (1) according to claim 1 or 2, wherein a tip portion of the pressing elastic sheet (130) is bent upwards and is formed with a slot (135) so as to form a holding portion (134), which is adapted to be held by an operator, on the pressing elastic sheet (130).

4. The photovoltaic connection box (10) according to claim 1, wherein
each of the conduction terminals is formed with a stub-shaped protrusion (120), in which a thread hole (121) is formed, and the base of the pressing elastic sheet (130) is formed with a through-hole (131); and
the pressing elastic sheet (130) is rotatably connected to the conduction terminal (100, 200) by a screw (140) passing through the through-hole (131) and screwed in the thread hole (121) of the stub-shaped protrusion (120).

5. The photovoltaic connection box (1) according to claim 4, wherein
the recession (111) has a flat internal bottom surface lower than an upper surface of the conduction terminal (100, 200);
the projection (112) has a flat lower surface higher than the upper surface of the conduction terminal (100, 200); and
the bus bar (40) inserted in the positioning slot (110) is defined between the internal bottom surface of the recession (111) and the lower surface of the projection (112).

6. The photovoltaic connection box (1) according to claim 5, wherein,
the internal bottom surface of the recession (111) is provided with soldering material for soldering the bus bar (40) on the internal bottom surface of the recession (111).

7. The photovoltaic connection box (1) according to claim 6, wherein,
the projection (112) is formed at one end of the recession (111) and is aligned with the recession (111).

8. The photovoltaic connection box (1) according to claim 1, wherein,
the conduction terminals (100, 200) comprise a positive conduction terminal (100) and a negative conduction terminal (200) separated from the positive conduction terminal (100);
and
the photovoltaic connection box (1) further comprises a diode (30) electrically connected between the positive conduction terminal (100) and the negative conduction terminal (200).

9. The photovoltaic connection box (1) according to claim 1, wherein
the photovoltaic box (1) further comprises a positive wire (10) electrically connected to positive conduction terminal (100) and a negative wire electrically connected to the negative conduction terminal (200).

10. A photovoltaic connection module, wherein, the module comprises:
a photovoltaic connection box (1) according to any one of claims 1 to 9; and
a solar panel,
wherein the bus bar (40) of the solar panel is inserted in the positioning slot (110) so as to be held in place; and
wherein the pressing elastic sheet (130) is arranged to press the bus bar (40) on the conduction terminal (100, 200), so that the bus bar (40) reliably comes into electrical contact with the conduction terminal (100, 200).

11. The photovoltaic connection module according to claim 10, wherein,
an internal bottom surface of the positioning slot (110) is provided with soldering material for soldering the bus bar (40) on the conduction terminal (100, 200).

## Patentansprüche

1. Photovoltaik-Anschlusskasten (1), der umfasst:
einen Kasten-Körper (1);
eine Vielzahl leitender Anschlüsse (100, 200), die in dem Kasten-Körper (1) aufgenommen sind; sowie
eine Vielzahl von Sammelschienen-Haltemechanismen, die an leitenden Anschlüssen (100, 200) vorhanden sind und jeweils so ausgeführt sind, dass sie Sammelschienen (40) eines Solarpanels an den leitenden Anschlüssen (100, 200) halten, um die Sammelschienen (40) elektrisch mit den leitenden Anschlüssen (100, 200) zu verbinden, wobei jeder Sammelschienen-Haltemechanismus umfasst:
einen Positionier-Schlitz (110), der an dem leitenden Anschluss (100, 200) ausgebildet und so eingerichtet ist, dass er die darin eingeführte Sammelschiene (40) fixiert, wobei der Positionier-Schlitz (110) durch eine Vertiefung (111) und einen Vorsprung (112) gebildet wird, die beide an der Oberfläche des leitenden Anschlusses (100, 200) ausgebildet sind; sowie
eine elastische Press-Zunge (130), die an dem leitenden Anschluss (100, 200) angebracht und so eingerichtet ist, dass sie die Sammelschiene (40) so an den leitenden Anschluss (100, 200) presst, dass die Sammelschiene (40) zuverlässig in elektrischen Kontakt mit dem leitenden Anschluss (100, 200) kommt, wobei eine Basis der elastischen Press-Zunge (130) drehbar mit einer Oberfläche des leitenden Anschlusses (100, 200) verbunden ist, um zuzulassen, dass sich die elastische Press-Zunge (130) zwischen einer ersten Position und einer zweiten Position dreht;
wenn die elastische Press-Zunge (130) die erste Position einnimmt, sich ein Pressabschnitt (132) der elastischen Press-Zunge (130) in der Vertiefung (111) befindet und die in den Positionier-Schlitz (110) eingeführte Sammelschiene (40) presst; und
wenn die elastische Press-Zunge (130) die zweite Position einnimmt, sich der Pressabschnitt (132) der elastischen Press-Zunge (130) außerhalb der Vertiefung (111) befindet und zulässt, dass die Sammelschiene (40) in den Positionier-Schlitz (110) eingeführt wird oder die Sammelschiene (40) aus dem Positionier-Schlitz (110) herausgezogen wird, **dadurch gekennzeichnet, dass** eine untere Fläche des Pressabschnitts (132) der elastischen Press-Zunge (130) mit einer Vielzahl vorstehender Rippen (133) versehen ist, die voneinander getrennt und zum Pressen der Sammelschiene (40) eingerichtet sind.

2. Photovoltaik-Anschlusskasten (1) nach Anspruch 1, wobei der Pressabschnitt (132) der elastischen Press-Zunge (130) nach unten vorsteht und so eingerichtet ist, dass er die in der Vertiefung (111) aufgenommene Sammelschiene (40) an eine innere Bodenfläche der Vertiefung (111) presst.

3. Photovoltaik-Anschlusskasten (1) nach Anspruch 1 oder 2, wobei ein vordere Abschnitt der elastischen Press-Zunge (130) nach oben gebogen und mit einem Schlitz (135) versehen ist, so dass an der elastischen Press-Zunge (130) ein Halteabschnitt (134) gebildet wird, der zum Halten durch eine Bedienungsperson eingerichtet ist.

4. Photovoltaik-Anschlusskasten (10) nach Anspruch 1, wobei
jeder der leitenden Anschlüsse mit einem zapfenförmigen Vorsprung (120) versehen ist, in dem ein Gewindeloch (121) ausgebildet ist, und die Basis der elastischen Press-Zunge (130) mit einem Durchgangsloch (131) versehen ist; und
die elastische Press-Zunge (130) mittels einer Schraube (140), die durch das Durchgangsloch (131) hindurchtritt und in das Gewindeloch (121) des zapfenförmigen Vorsprungs (120) eingeschraubt wird, drehbar mit dem leitenden Anschluss (100, 200) verbunden ist.

5. Photovoltaik-Anschlusskasten (1) nach Anspruch 4, wobei
die Vertiefung (111) eine ebene innere Bodenfläche hat, die tiefer liegt als eine obere Fläche des leitenden Anschlusses (100, 200);
der Vorsprung (112) eine ebene untere Fläche hat, die höher liegt als die obere Fläche des leitenden Anschlusses (100, 200); und
die in den Positionier-Schlitz (110) eingeführte Sammelschiene (40) zwischen der inneren Bodenfläche der Vertiefung (111) und der unteren Fläche des Vorsprungs (112) ausgebildet ist.

6. Photovoltaik-Anschlusskasten (1) nach Anspruch 5, wobei
die innere Bodenfläche der Vertiefung (111) mit Lötmaterial zum Anlöten der Sammelschiene (40) an der inneren Bodenfläche der Vertiefung (111) versehen ist.

7. Photovoltaik-Anschlusskasten (1) nach Anspruch 6, wobei
der Vorsprung (112) an einem Ende der Vertiefung (111) ausgebildet und auf die Vertiefung (111) ausgerichtet ist.

8. Photovoltaik-Anschlusskasten (1) nach Anspruch 1, wobei
die leitenden Anschlüsse (100, 200) einen positiven leitenden Anschluss (100) und einen negativen leitenden Anschluss (200) umfassen, der von dem positiven leitenden Anschluss (100) getrennt ist; und
der Photovoltaik-Anschlusskasten (1) des Weiteren eine Diode (30) umfasst, die elektrisch zwischen den positiven leitenden Anschluss (100) und den negativen leitenden Anschluss (200) geschaltet ist.

9. Photovoltaik-Anschlusskasten (1) nach Anspruch 1, wobei
der Photovoltaik-Kasten (1) des Weiteren einen positiven Leiter (10), der elektrisch mit dem positiven leitenden Anschluss (100) verbunden ist, und einen negativen Leiter umfasst, der elektrisch mit dem negativen leitenden Anschluss (200) verbunden ist.

10. Photovoltaik-Anschlussmodul, wobei das Modul umfasst:
einen Photovoltaik-Anschlusskasten (1) nach einem der Ansprüche 1 bis 9; sowie ein Solarpanel,
wobei die Sammelschiene (40) des Solarpanels in den Positionier-Schlitz (110) eingeführt und so fixiert ist; und
die elastische Press-Zunge (130) so angeordnet ist, dass sie die Sammelschiene (40) so an den leitenden Anschluss (100, 200) presst, dass die Sammelschiene (40) zuverlässig in elektrischen Kontakt mit dem leitenden Anschluss (100, 200) kommt.

11. Photovoltaik-Anschlussmodul nach Anspruch 10, wobei,
eine innere Bodenfläche des Positionier-Schlitzes (110) mit Lötmaterial zum Anlöten der Sammelschiene (40) an dem leitenden Anschluss (100, 200) versehen ist.

## Revendications

1. Boîte de jonction photovoltaïque (1), comprenant:
un corps de boîte (1);
une pluralité de bornes de conduction (100, 200) reçues dans le corps de la boîte (1); et
une pluralité de mécanismes de maintien de barres omnibus prévus sur les bornes de conduction (100, 200), et configurés pour maintenir les barres omnibus (40) d'un panneau solaire sur les bornes de conduction (100, 200), respectivement, de manière à connecter électriquement les barres omnibus (40) aux bornes de conduction (100, 200), chaque mécanisme de maintien de barres omnibus comprenant:
une fente de positionnement (110) formée sur la borne de conduction (100, 200) et conçue pour positionner en place la barre bus (40) qui y est insérée, dans lequel la fente de positionnement (110) est définie par un creux (111) et une saillie (112) tous deux formés sur la surface de la borne de conduction (100, 200); et
une feuille élastique de pressage (130) montée sur la borne de conduction (100, 200) et conçue pour presser la barre omnibus (40) sur la borne de conduction (100, 200), de sorte que la barre omnibus (40) entre en contact électrique de manière fiable avec la borne de conduction (100, 200), dans laquelle une base de la feuille élastique de pressage (130) est connectée de manière rotative à une surface de la borne de conduction (100, 200), de manière à permettre à la feuille élastique de pressage (130) de tourner entre une première position et une seconde position;
lorsque la feuille élastique de pressage (130) est dans la première position, une partie de pressage (132) de la feuille élastique de pressage (130) est située dans le creux (111) de manière à presser la barre omnibus (40) insérée dans la fente de positionnement (110); et
lorsque la feuille élastique de pression (130) est dans la seconde position, la partie de pression (132) de la feuille élastique de pression (130) est située à l'extérieur du creux (111), de manière à permettre d'insérer la barre omnibus (40) dans la fente de positionnement (110) ou de tirer la barre omnibus (40) hors de la fente de positionnement (110),
**caractérisé en ce qu'**une surface inférieure de la partie de pression (132) de la feuille élastique de pression (130) est munie d'une pluralité de nervures saillantes (133) séparées les unes des autres et conçues pour appuyer contre la barre omnibus (40).

2. Boîte de jonction photovoltaïque (1) selon la revendication 1, dans laquelle la partie de pression (132) de la feuille élastique de pression (130) fait saillie vers le bas et est conçue pour presser la barre omnibus (40) reçue dans la cavité (111) contre une surface inférieure interne de la cavité (111).

3. Boîte de jonction photovoltaïque (1) selon les revendications 1 ou 2, dans laquelle une partie de pointe de la feuille élastique de pression (130) est pliée vers le haut et est formée avec une fente (135) de manière à former une partie de maintien (134), qui est conçue pour être maintenue par un opérateur, sur la feuille élastique de pression (130).

4. Boîte de jonction photovoltaïque (10) selon la revendication 1, dans laquelle chacune des bornes de conduction est formée avec une saillie en forme de talon (120), dans laquelle un trou de filetage (121) est formé, et la base de la feuille élastique de pression (130) est formée avec un trou traversant (131); et
la feuille élastique de pressage (130) est reliée de manière rotative à la borne de conduction (100, 200) par une vis (140) passant par le trou traversant (131) et vissée dans le trou fileté (121) de la saillie en forme de tronçon (120).

5. Boîte de jonction photovoltaïque (1) selon la revendication 4, dans laquelle la récession (111) présente une surface inférieure interne plane plus basse qu'une surface supérieure de la borne de conduction (100, 200);
la saillie (112) a une surface inférieure plate plus haute que la surface supérieure de la borne de conduction (100, 200); et
la barre omnibus (40) insérée dans la fente de positionnement (110) est définie entre la surface inférieure interne de la récession (111) et la surface inférieure de la saillie (112).

6. Boîte de jonction photovoltaïque (1) selon la revendication 5, dans laquelle, la surface inférieure interne de la récession (111) est pourvue d'un matériau de soudure pour souder la barre omnibus (40) sur la surface inférieure interne de la récession (111).

7. Boîte de jonction photovoltaïque (1) selon la revendication 6, dans laquelle, la projection (112) est formée à une extrémité de la récession (111) et est alignée avec la récession (111).

8. Boîte de jonction photovoltaïque (1) selon la revendication 1, dans laquelle, les bornes de conduction (100, 200) comprennent une borne de conduction positive (100) et une borne de conduction négative (200) séparée de la borne de conduction positive (100); et
la boîte de jonction photovoltaïque (1) comprend en outre une diode (30) connectée électriquement entre la borne de conduction positive (100) et la borne de conduction négative (200).

9. Boîte de jonction photovoltaïque (1) selon la revendication 1, dans laquelle la boîte photovoltaïque (1) comprend en outre un fil positif (10) connecté électriquement à la borne de conduction positive (100) et un fil négatif connecté électriquement à la borne de conduction négative (200).

10. Module de connexion photovoltaïque, dans lequel, le module comprend:
une boîte de jonction photovoltaïque (1) selon l'une quelconque des revendications 1 à 9; et
un panneau solaire,
dans lequel la barre omnibus (40) du panneau solaire est insérée dans la fente de positionnement (110) de manière à être maintenue en place dans lequel la feuille élastique de pressage (130) est disposée de manière à presser la barre omnibus (40) sur la borne de conduction (100, 200), de sorte que la barre omnibus (40) entre en contact électrique de manière fiable avec la borne de conduction (100, 200).

11. Module de connexion photovoltaïque selon la revendication 10, dans lequel, une surface inférieure interne de la fente de positionnement (110) est pourvue d'un matériau de soudure pour souder la barre omnibus (40) sur la borne de conduction (100, 200).
